(19) Europäisches Patentamt
European Patent Office
Office européen des brevets

(11) **EP 3 910 355 B1**

(12) **EUROPÄISCHE PATENTSCHRIFT**

(45) Veröffentlichungstag und Bekanntmachung des Hinweises auf die Patenterteilung:
**31.08.2022   Patentblatt 2022/35**

(21) Anmeldenummer: **21000098.0**

(22) Anmeldetag: **06.04.2021**

(51) Internationale Patentklassifikation (IPC):
***G01R 31/52*** *(2020.01)*   ***G01R 31/08*** *(2020.01)*
***G01R 27/18*** *(2006.01)*

(52) Gemeinsame Patentklassifikation (CPC):
**G01R 31/52; G01R 31/086;** G01R 27/18

(54) **VERFAHREN ZUR ERKENNUNG UND/ODER ORTUNG VON ERDSCHLÜSSEN**

METHOD FOR DETECTING AND / OR LOCATING GROUND FAULTS

PROCÉDÉ DE DÉTECTION ET/OU DE LOCALISATION DE COURTS-CIRCUITS À LA TERRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.04.2020   DE 102020002618**

(43) Veröffentlichungstag der Anmeldung:
**17.11.2021   Patentblatt 2021/46**

(73) Patentinhaber: **A. Eberle GmbH & Co. KG**
**90461 Nürnberg (DE)**

(72) Erfinder:
• **Maisel, Thilo**
**90461 Nürnberg (DE)**

• **Hofbeck, Martin**
**90461 Nürnberg (DE)**

(74) Vertreter: **Schuhmann, Albrecht**
**c/o Merten Patentmanagement**
**Alexanderstrasse 1**
**90547 Stein (DE)**

(56) Entgegenhaltungen:
**EP-A1- 1 682 909         AT-A2- 500 195**
**US-A1- 2013 043 879**

Bemerkungen:
Die Akte enthält technische Angaben, die nach dem Eingang der Anmeldung eingereicht wurden und die nicht in dieser Patentschrift enthalten sind.

**Beschreibung**

Die vorliegende Erfindung betrifft ein Verfahren zur Erkennung und/oder Ortung von insbesondere transienten Erdschlüssen in Leitungsabzweigen und/oder Leitungen von Stromversorgungsnetzen für Fehlerwiderstände bis in den Bereich von einigen kOhm. Insbesondere betrifft die erfindungsgemäße Ausführung eine Verbesserung der bekannten Verfahren zur Erkennung und/oder Ortung von Erdschlüssen des einmalig zündenden, des wiederzündenden und des intermittierenden Erdschlusses für Fehlerwiderstände bis in den Bereich von einigen kOhm.

Die heute üblicherweise eingesetzte Ansprechschwelle zum Start der Ortungsverfahren ist die Verlagerungsspannung. Diese Verfahren, wie in der DE10225058 oder der EP0812427 als Verfahren zur Erkennung eines einpoligen Fehlers im Drehstromnetz genannt, verursachen vor allem bei hochohmigen Fehlern das Problem, dass der Fehlereintritt und der Zeitpunkt des Ansprechens zeitlich um einige Netzperioden auseinander liegen können. Damit wird die Auswertung der korrekten Fehlergrößen erschwert, oder im schlechtesten Fall Falschanzeigen erzeugt. Weitere Verfahren zur Erkennung von transienten Erdschlüssen sind aus EP 1 682 909 A1, AT 500 195 A2 und US 2013/043879 A1 bekannt.

In bekannten Verfahren ist insbesondere die Fehlertoleranz bei der Messung oder die unterschiedlich heranzuziehenden Fehlerarten und somit benötigtes anderes Verfahren für eine Ortung ungenau oder sehr aufwendig.

Aufgabe der vorliegenden Erfindung ist es daher eine Vorrichtung und/oder ein Verfahren bereitzustellen, was die Probleme minimiert, dabei den Zeitpunkt des Fehlereintritts exakt bestimmt, möglichst tolerant gegenüber Winkelmessfehlern ist und dabei robust und kostengünstig ausgeführt ist. Ebenso ist die Aufgabe der vorliegenden Erfindung, selektiv den Abgang bei einmal zündenden Erdschlüssen (Erdschlusswischern), wiederzündenden Erdschlüssen, Einsatz der Pulsortung zu erkennen und gerichtet anzeigen zu können.

Diese Aufgabe wird mit den Merkmalen des kennzeichnenden Teils des Anspruchs 1 gelöst. Fortbildungen und vorteilhafte Ausführungen der Erfindung sind in den weiteren Ansprüchen umfasst.

Erfindungsgemäß ist ein Verfahren zur Erkennung und/oder Ortung von transienten Erdschlüssen in Leitungsabzweigen und/oder Leitungen von Stromversorgungsnetzen für Fehlerwiderstände bis in den Bereich von einigen kOhm wobei

a) ein kontinuierliches Abtasten und Speichern der Verlagerungsspannung u0(t) und des Summenstromes 3io(t) in einem Abgang erfolgt.
b) die Abtastwerte in einem digitalen Datenverarbeitungssystem mit Datenpuffer abgelegt werden.
c) eine Filterung der abgetasteten Größen u0(t) und 3io(t) mit Hilfe eines digitalen, orthogonalen Filters bezugnehmend auf die Grundschwingung zur Ermittlung der orthogonalen Komponenten uoc(k) oder uos(k) oder ioc(k) oder ios(k) in jedem Abtastschritt von u0(t) und 3io(t) erfolgt.
d) eine Berechnung der komplexen Admittanz, das heißt Betrag $|Y(t)|$, Realteil Yre(t) und Imaginärteil Yim(t), in jedem Abtastschritt k aus den in Schritt (c) gefilterten Werten und Abspeichern der Ergebnisse in einem Ringspeicher erfolgt.
e) Der Ringspeicher in jedem Abtastschritt mit dem Betrag der Admittanz gefüllt wird.
f) Die Bildung folgender Größen in jedem Abtastschritt k aus dem Ringspeicher mittels der Berechnungen für

$$\sum \underline{Y}(n) = \sum_{i=n-N+1}^{i=n} \underline{Y}_i$$

Gleitende Summe der Admittanzwerte:

Gleitende Summe der Quadrate der

$$\sum \underline{Y}^2(n) = \sum_{i=n-N+1}^{i=n} \underline{Y}_i^2$$

Admittanzwerte:

Normierte Varianz der Admittanzwerte:

$$\sigma^2(n) = \frac{N}{N-1}\left[\frac{N\sum \underline{Y}^2(n)}{\left(\sum \underline{Y}(n)\right)^2} - 1\right]$$ erfolgt,

g) und somit ein Fehler oder Erdschluss bei Überschreitung des Betrages der normierten Varianz mit einem Schwellwert in einem Abtastschritt wobei der aktuelle Abtastschritt damit der Index des Fehlereintritts $idx_{thr}$ erkannt wird.

Erfindungsgemäß wird ein Verfahren beschrieben, dass auf der Zustandsänderung der Nullsystemgrößen UNE und 3Io beruht. Die Zustandsänderung wird einmal durch den Eintritt des Erdschlusses oder durch Einspeisen eines künstlichen Signals (Taktschrank) in das Nullsystem hervorgerufen. Diese Zustandsänderung wird dabei durch eine zeitabhängige Nulladmittanz Yo beschrieben.

Zur Erkennung eines Fehlers wird die Varianz (Quadrat der Standardabweichung) über einen gleitenden Mittelwert des berechneten Betrags der Nulladmittanz Yo verwendet. Diese Art der Fehlererkennung ersetzt damit die übliche Erkennungsschwelle aus der Verlagerungsspannun Uo

Hier zeigt es sich dann, dass sich der Zeitpunkt des Fehlereintritts und der Zeitpunkt des Überschreitens der Ansprechschwelle nur unwesentlich voneinander unterscheidet. Was demzufolge eine einfache und schnelle Auswertung der Fehlergrößen ermöglicht.

Weiter kommt hinzu, dass auch noch eine hohe Empfindlichkeit bei großen Fehlerwiderständen erreicht wird. Der Fehlerwiderstand an der Fehlerstelle kann dabei Werte bis einige $k\Omega$ annehmen.

Ein Vorteil besteht in dem hohen Störabstand zwischen fehlerhaftem und fehlerfreiem Zustand im jeweils betrachteten Abgang. Damit stellt das Verfahren geringe Anforderung an die Messgenauigkeit der eingesetzten Strom- bzw. Spannungswandler. Auch wird hiermit eine Überfunktion der Erdschlussfunktion in den gesunden Abgängen vermieden.

Ein weiterer Vorteil des Verfahrens besteht in der einfachen Parametrierbarkeit, da in diesem Fall nur ein Parameter zur Einstellung notwendig ist:

Die auf die Erkennung eines Erdschlusses folgende Ortung wird dabei bevorzugt mittels der kontinuierlich ermittelten und abgespeicherten Signale der Verlagerungsspannung und des Summenstromes ermittelt. Hierbei erfolgt die Richtungsauswertung des Fehlers oder Erdschlusses mittels folgender Berechnungen und zunächst Eliminierung der Vorfehler der im Ringspeicher vorhandenen zugehörigen Signale uo(t) und 3io(t) durch Speichern von n-Vorfehler Perioden von uo(t) und 3io(t) von $idx_{thr} - n*N + N/2$ bis $idx_{thr} + N/2$ in uo_buff_prefault bzw. 3io_buff_prefault, durch

$$u_{0,buff,prefault} = u_0\left( idx_{thr} - nN + \frac{N}{2} : idx_{thr} + \frac{N}{2} \right)$$

$$3i_{0,buff,prefault} = 3i_0\left( idx_{thr} - nN + \frac{N}{2} : idx_{thr} + \frac{N}{2} \right)$$

Danach erfolgt die Summation der n-Vorfehlerperioden und Normierung

$$u_{0,buff,prefault,sum} = \frac{1}{n}\sum_{k=1}^{n} u_{0,buff,prefault}(1 + (k-1)N : kN)$$

$$3i_{0,buff,prefault,sum} = \frac{1}{n}\sum_{k=1}^{n} 3i_{0,buff,prefault}(1 + (k-1)N : kN)$$

Dann wird der Gleichanteil aus den in Schritt (2) ermittelten Signalen ermitteln, durch

$$u_{0,buff,prefault,av} = \frac{1}{N}\int_{1}^{N} u_{0,buff,prefault,sum}$$

$$3i_{0,buff,prefault,av} = \frac{1}{N}\int_{1}^{N} 3i_{0,buff,prefault,sum}$$

Der Gleichanteil aus den Signalen von Schritt (2) wird abgezogen

$$u_{0,buff,prefault,korr} = u_{0,buff,prefault,sum} - u_{0,buff,prefault,av}$$

$$3i_{0,buff,prefault,korr} = 3i_{0,buff,prefault,sum} - 3i_{0,buff,prefault,av}$$

Abziehen der Vorfehlergrößen von den Signalen in Schritt (1)

$$u_{0,buff,prefault,off} = u_{0,buff,prefault} - u_{0,buff,prefault,korr}$$

$$3i_{0,buff,prefault,off} = 3i_{0,buff,prefault} - 3i_{0,buff,prefault,korr}$$

Danach erfolgt die Neuberechnung der Fehler korrigierten Admittanz mit Hilfe eines orthogonalen Filters. Man erhält nun $Y_{re,off}(t)$ , $Y_{im,off}(t)$ und $|Y_{off}(t)|$
Zur Richtungsauswertung wird zunächst ein Auswerteintervall mit den Grenzen eval_end_idx und eval_start_idx folgendermaßen bestimmt

1) Finden des Maximums aus $|Y_{off}(t)|$->idx_max
2) Rückwärtssuche in $|Y_{off}(t)|$ ab dem Index des Maximums, bis zum Index idx_zero bei dem keine Steigung mehr in $|Y_{off}(t)|$ erkannt wird.
3) Eval_start_idx = idx_zero - N/10
4) Eval_end_idx = idx_max + N/10

k) Summation der in Schritt (11) berechneten Admittanzwerte:

$$Y_{eval,re,sum} = \frac{1}{\left(eval_{end,idx} - eval_{start,idx}\right)} \sum_{eval_{start,idx}}^{eval_{end,idx}} Y_{re,off}$$

$$Y_{eval,im,sum} = \frac{1}{\left(eval_{end,idx} - eval_{start,idx}\right)} \sum_{eval_{start,idx}}^{eval_{end,idx}} Y_{im,off}$$

1) Richtungsbestimmung anhand einer Vorzeichenbewertung aus den in Schritt k) ermittelten Summenadmittanzwerten

| $Y_{eval,re,sum}$ | $Y_{eval,im,sum}$ | Richtung |
|---|---|---|
| + | + | Rückwärts |
| - | + | Vorwärts |
| - | - | Vorwärts |
| + | - | Rückwärts |

oder
Richtungsauswertung Pulsortung wobei als Erkennung die mögliche Admittanzänderung (mit Sicherheitsfaktor) die durch die Pulseinrichtung erzeugt wird herangezogen wird.
Im Folgenden wird die Erfindung anhand von Zeichnungen beispielhaft näher beschrieben, dabei zeigen:

Fig. 1    Messung der Verlagerungsspannung.
Fig. 2    Messung des Summenstromes.
Fig. 3    Darstellung eines Erdschlusswischers.
Fig. 4    Messignal nach einem Tiefpass Vorfilter.
Fig. 5    Hüllkurven.
Fig. 6    Admittanz- und Varianzverlauf
Fig. 7    Beispiel für Richtungsauswertung.

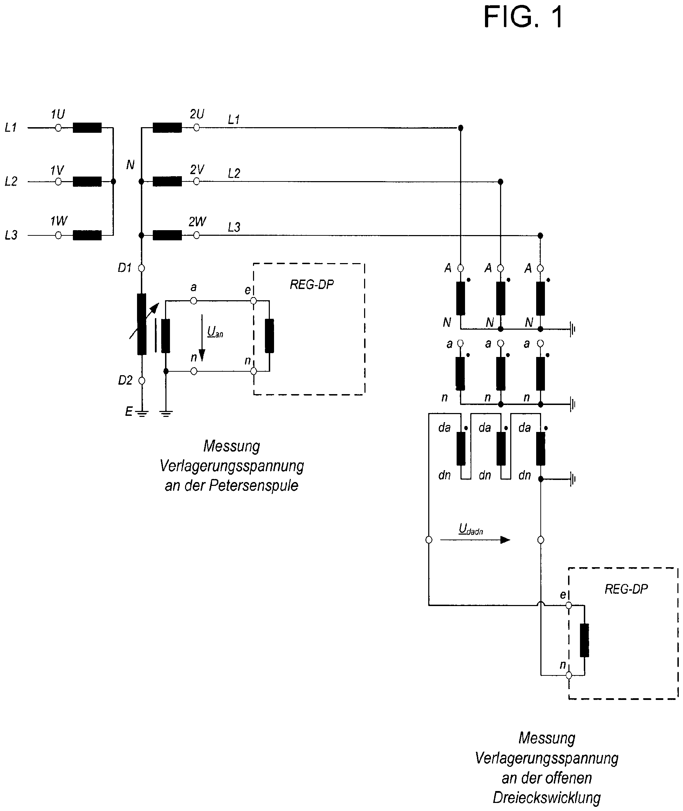

Wie in Fig. 1 gezeigt, kann die Verlagerungsspannung $u_0(t)$ auf verschiedene Art ermittelt werden, wie durch:

- Messung der drei Leiter-Erde Spannungen $u_{1E}(t)$, $u_{2E}(t)$ und $u_{3E}(t)$ an einer beliebigen Stelle im Netz von drei einpoligen Spannungswandlern und anschließende numerische Berechnung von

$$u_0(t) = \frac{1}{3}\left(u_{1E}(t) + u_{2E}(t) + u_{3E}(t)\right).$$

- Messung der Verlagerungsspannung $u_{dadn}(t)$ an der offenen Dreieckswicklung eines einpoligen Spannungswandlersatzes.
- Messung der Verlagerungsspannung $u_{an}(t)$ an der Messwicklung der Petersenspule.

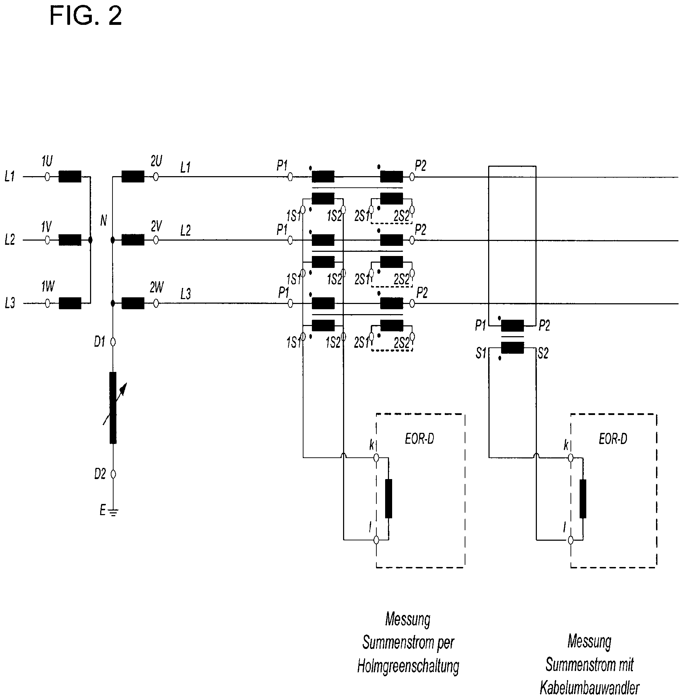

Ebenso kann gemäß Fig. 2 die Messung des Summenstroms $3i_0(t)$ auf verschiedene Art ermittelt werden, wie:

- Messung der drei Leiterströme $i_{L1}(t)$, $i_{L2}(t)$ und $i_{L3}(t)$ in dem zu überwachenden Leitungsabgang und anschließende numerische Berechnung von

$$3i_0(t) = i_{L1}(t) + i_{L2}(t) + i_{L3}(t)$$

- Messung des Summenstromes $3i_0(t)$ mit Hilfe der Holmgreenschaltung. Dabei werden die Stromwandlersekundärkreise der drei Leiterströme parallelgeschaltet. Die Addition der drei Leiterströme durch die Parallelschaltung ergibt den Summenstrom.
- Messung des Summenstromes $3i_0(t)$ mit Hilfe eines Kabelumbauwandlers.

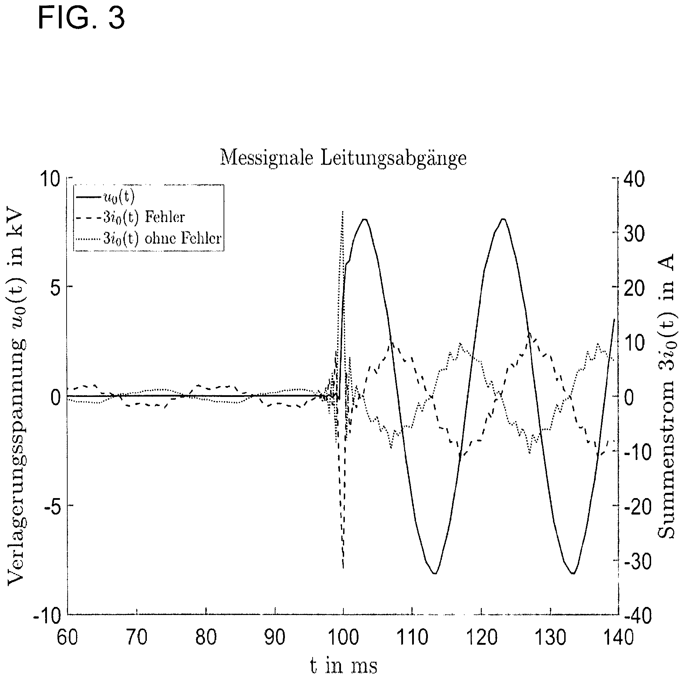

Als Beispiel zeigt die Abbildung in Fig. 3 einen Erdschlusswischer mit zwei Leitungsabgängen (rot fehlerbehaftet, grün Abgang ohne Fehler).

Zusehen sind die originalen Messgrößen Verlagerungsspannung (blau) uo(t) und die Summenströme 3io(t) aus dem fehlerbehafteten (rot) sowie dem fehlerfreien (grün) Leitungsabgang. Der Fehler tritt gemäß diesem Beispiel bei t = tf = 100ms ein.

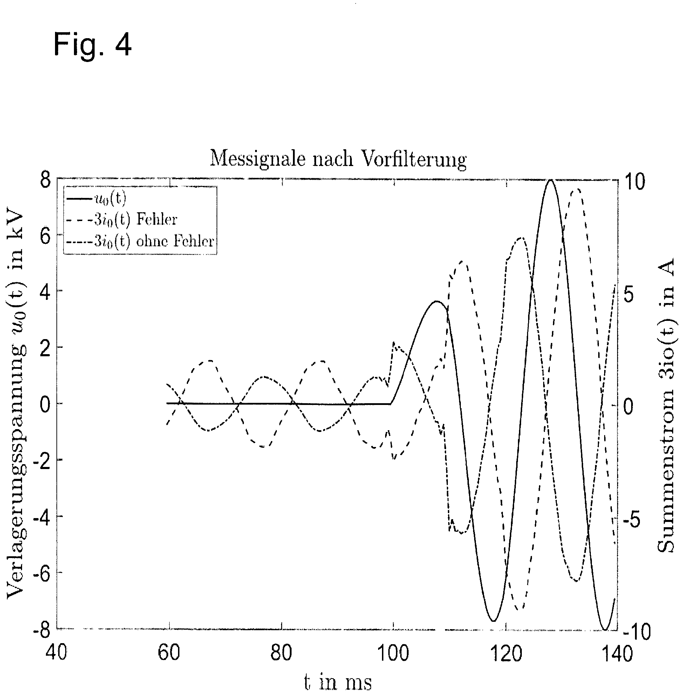

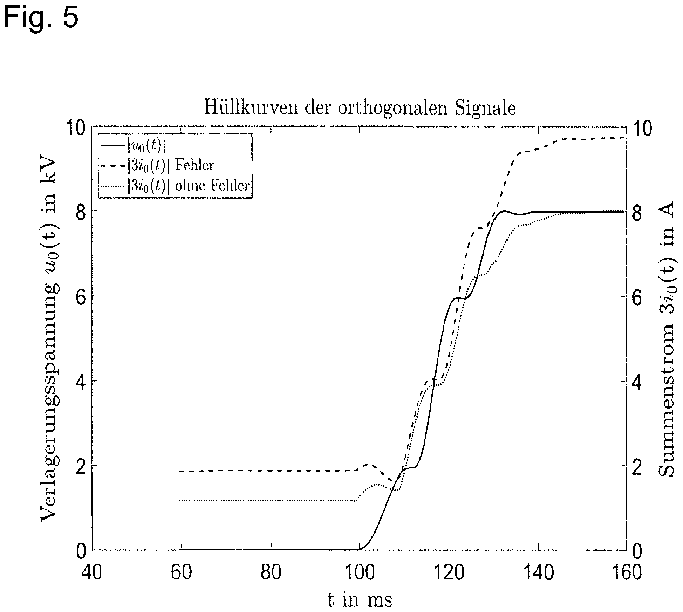

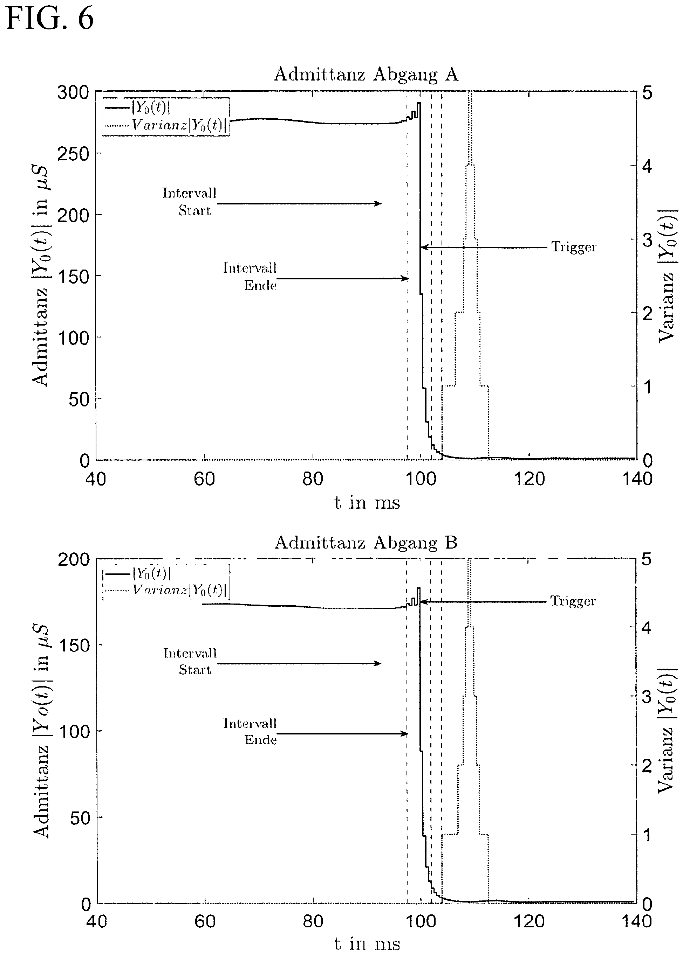

Ein entsprechend optimiertes Messsignal nach dem Tiefpass Vorfilter ist in Fig. 4 gezeigt. In der Fig. 5 sind beispielhaft die berechneten Hüllkurven (Betrag der Amplitude) aus den Signalwerten des orthogonalen Filters mit der Filtergrundfrequenz fg = 50Hz dargestellt. Ein beispielhafter Admittanz- und Varianzverlauf ist in Fig. 6 dargestellt, hierbei zeigen die verwendeten Strom- und Spannungssignale schon einen speziellen Verlauf da bei Fehlereintritt die Admittanz (blau) kleiner wird. Dieser Fehler wird jedoch auch richtig erkannt, es ergibt sich eine deutliche Änderung in der Varianz (gelb) der Admittanz Yo. Die gestrichelten Linien geben den Zeitpunkt für die Erkennung (rot) sowie das Auswerteintervall (Start und Ende) an.

Abgang A -> Abgang mit Fehler
Abgang B -> Abgang ohne Fehler

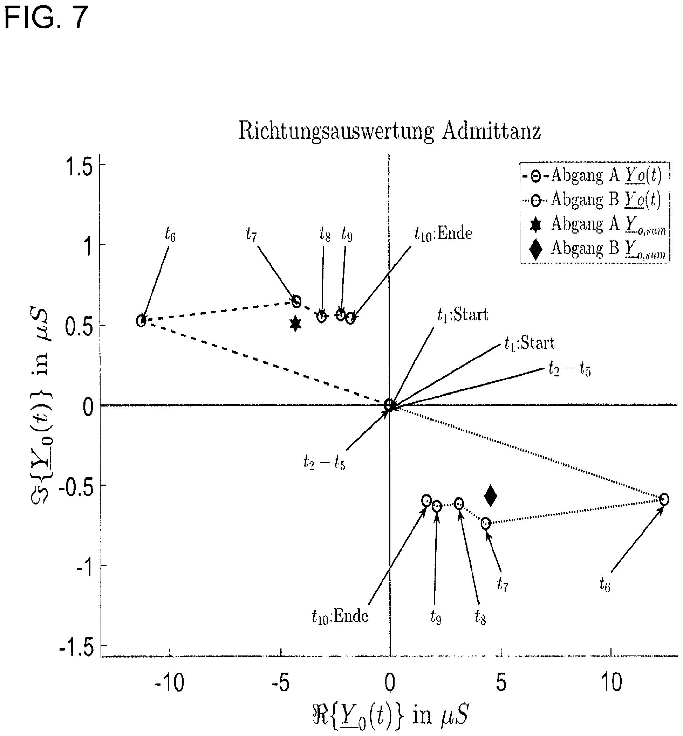

Das beispielhaft gezeigte Diagramm gemäß Fig. 7 zeigt nun die Richtungsauswertung der beiden Abgänge A und B.

Bei dem fehlerbehafteten Abgang A liegt die Trajektorie bzw. Summation von Yo in der linken Halbebene was einen Fehler in Vorwärtsrichtung bedeuten würde.

Für den Abgang B, dem fehlerfreien Abgang, liegt die Trajektorie bzw. die Summation entsprechend in der rechten Halbebene.

Damit ist es möglich den fehlerbehafteten vom fehlerfreien Abgang zu unterscheiden und entsprechende Maßnahmen einzuleiten.

**Patentansprüche**

1.  Verfahren zur Erkennung und/oder Ortung von transienten Erdschlüssen in Leitungsabzweigen und/oder Leitungen von Stromversorgungsnetzen für Fehlerwiderstände bis in den Bereich von einigen kOhm wobei das Verfahren die folgenden Schritte umfasst:

    a) Kontinuierliches Abtasten und speichern der Verlagerungsspannung u0(t) und des Summenstromes 3io(t) in einem Abgang.
    b) Ablegen der Abtastwerte in einem digitalen Datenverarbeitungssystem mit Datenpuffer.

    **gekennzeichnet durch** die folgenden Schritte:

    c) Filterung der abgetasteten Größen u0(t) und 3io(t) mit Hilfe eines digitalen, orthogonalen Filters bezugnehmend auf die Grundschwingung zur Ermittlung der orthogonalen Komponenten uoc(k) oder uos(k) oder ioc(k) oder ios(k) in jedem Abtastschritt von u0(t) und 3io(t).
    d) Berechnung der komplexen Admittanz, das heißt Betrag |Y(t)|, Realteil Yre(t) und Imaginärteil Yim(t), in jedem Abtastschritt k aus den in Schritt (c) gefilterten Werten und Abspeichern der Ergebnisse in einem Ringspeicher.
    e) Füllung des Ringspeichers in jedem Abtastschritt mit dem Betrag der Admittanz.
    f) Bildung folgender Größen in jedem Abtastschritt k aus dem Ringspeicher mittels der Berechnungen für Glei-

$$\sum \underline{Y}(n) = \sum_{i=n-N+1}^{i=n} \underline{Y}_i$$

tende Summe der Admittanzwerte:                    Gleitende Summe der Quadrate der Admit-

$$\sum \underline{Y}^2(n) = \sum_{i=n-N+1}^{i=n} \underline{Y}_i^2$$

tanzwerte:                    Normierte    Varianz    der    Admittanzwerte:

$$\sigma^2(n) = \frac{N}{N-1}\left[\frac{N\sum \underline{Y}^2(n)}{\left(\sum \underline{Y}(n)\right)^2} - 1\right]$$

    g) Feststellung eines Fehlers oder Erdschlusses bei Überschreitung des Betrages der normierten Varianz mit einem Schwellwert in einem Abtastschritt wobei der aktuelle Abtastschritt damit der Index des Fehlereintritts $idx_{thr}$ ist.

2.  Verfahren zur Erkennung und/oder Ortung von Erdschlüssen nach Anspruch 1, weiter **gekennzeichnet durch** folgende Schritte:

    h) Richtungsauswertung des Fehlers oder Erdschlusses mittels folgender Berechnungen und Eliminierung der Vorfehler von im Ringspeicher vorhandenen zugehörigen Signalen uo(t) und 3io(t).

    1) Speichern von n Vorfehlerperioden von uo(t) und 3io(t) von $idx_{thr}$ - n*N + N/2 bis $idx_{thr}$ + N/2 in uo_buff_prefault bzw. 3io_buff_prefault

$$u_{0,buff,prefault} = u_0\left(idx_{thr} - nN + \frac{N}{2} : idx_{thr} + \frac{N}{2}\right)$$

$$3i_{0,buff,prefault} = 3i_0\left(idx_{thr} - nN + \frac{N}{2} : idx_{thr} + \frac{N}{2}\right)$$

2) Summation der n Vorfehlerperioden und Normierung

$$u_{0,buff,prefault,sum} = \frac{1}{n}\sum_{k=1}^{n} u_{0,buff,prefault}\left(1+(k-1)N:kN\right)$$

$$3i_{0,buff,prefault,sum} = \frac{1}{n}\sum_{k=1}^{n} 3i_{0,buff,prefault}\left(1+(k-1)N:kN\right)$$

3) Gleichanteil aus den in Schritt (2) ermittelten Signalen ermitteln

$$u_{0,buff,prefault,av} = \frac{1}{N}\int_{1}^{N} u_{0,buff,prefault,sum}$$

$$3i_{0,buff,prefault,av} = \frac{1}{N}\int_{1}^{N} 3i_{0,buff,prefault,sum}$$

4) Gleichanteil aus den Signalen von Schritt (2) abziehen

$$u_{0,buff,prefault,korr} = u_{0,buff,prefault,sum} - u_{0,buff,prefault,av}$$

$$3i_{0,buff,prefault,korr} = 3i_{0,buff,prefault,sum} - 3i_{0,buff,prefault,av}$$

5) Abziehen der Vorfehlergrößen von den Signalen in Schritt (1)

$$u_{0,buff,prefault,off} = u_{0,buff,prefault} - u_{0,buff,prefault,korr}$$

$$3i_{0,buff,prefault,off} = 3i_{0,buff,prefault} - 3i_{0,buff,prefault,korr}$$

i) Neuberechnung der fehlerkorrigierten Admittanz mit Hilfe eines orthogonalen Filters. Man erhält nun $Y_{re,off}(t)$, $Y_{im,off}(t)$ und $|Y_{off}(t)|$

j) Zur Richtungsauswertung wird zunächst ein Auswerteintervall mit den Grenzen eval_end_idx und eval_start_idx folgendermaßen bestimmt

5) Finden des Maximums aus $|Y_{off}(t)|$ -> idx_max

6) Rückwärtssuche in $|Y_{off}(t)|$ ab dem Index des Maximums, bis zum Index idx_zero bei dem keine Steigung mehr in $|Y_{off}(t)|$ erkannt wird.

7) Eval_start_idx = idx_zero - N/10

8) Eval_end_idx = idx_max + N/10

k) Summation der in Schritt (11) berechneten Admittanzwerte:

$$Y_{eval,re,sum} = \frac{1}{\left(eval_{end,idx} - eval_{start,idx}\right)} \sum_{eval_{start,idx}}^{eval_{end,idx}} Y_{re,off}$$

$$Y_{eval,im,sum} = \frac{1}{\left(eval_{end,idx} - eval_{start,idx}\right)} \sum_{eval_{start,idx}}^{eval_{end,idx}} Y_{im,off}$$

1) Richtungsbestimmung anhand einer Vorzeichenbewertung aus den in Schritt k) ermittelten Summenadmittanzwerten

| $Y_{eval,re,sum}$ | $Y_{eval,im,sum}$ | Richtung |
|---|---|---|
| + | + | Rückwärts |
| - | + | Vorwärts |
| - | - | Vorwärts |
| + | - | Rückwärts |

oder
Richtungsauswertung Pulsortung wobei als Erkennung die mögliche Admittanzänderung mit Sicnerheitsfaktor die durch die Pulseinrichtung erzeugt wird herangezogen wird.

3. Verfahren zur Erkennung und/oder Ortung von transienten Erdschlüssen nach Anspruch 1,
**dadurch gekennzeichnet,**
**dass** die Abtastrate frei festlegbar ist.

4. Verfahren zur Erkennung und/oder Ortung von transienten Erdschlüssen nach Anspruch 1,
**dadurch gekennzeichnet,**
**dass** die Datenverarbeitung der gepufferten Daten und deren Auswertung zur schnellen Erkennung von Änderungen gleitend erfolgt

5. Verfahren zur Erkennung und/oder Ortung von transienten Erdschlüssen nach Anspruch 1,
**dadurch gekennzeichnet,**
**dass** die Abtastung und Ermittlung der jeweiligen Verlagerungsspannung u0(t) und des Summenstromes 3io(t) mittels einer Vorfilterung mit einem Tiefpass-Filter erfolgt.

6. Verfahren zur Erkennung und/oder Ortung von transienten Erdschlüssen nach Anspruch 1 und 5,
**dadurch gekennzeichnet,**
**dass** vorgegebene Grundfrequenzen für den Filter wählbar sind und/oder harmonische Frequenzen gefiltert und ausgewertet werden.

7. Verfahren zur Erkennung und/oder Ortung von transienten Erdschlüssen nach Anspruch 1,
**dadurch gekennzeichnet,**
**dass** die berechneten Admittanzwerte nach Erkennung noch mindestens für k_end Abtastschritte in den Ringspeicher geschrieben werden.

**Claims**

1. A method for detecting and/or locating transient ground faults in line branches and/or lines of power supply networks for fault resistances up to the range of a few kOhm, wherein the method comprises the following steps:

a) continuously sampling and storing the residual voltage u0(t) and the total current 3io(t) in an outgoing line
b) storing the sampled values in a digital data processing system with data buffer

**characterized by** the following steps:

c) filtering the sampled variables u0(t) and 3io(t) with the aid of a digital orthogonal filter with reference to the fundamental component in order to determine the orthogonal components uoc(k) or uos(k) or ioc(k) or ios(k) in each sampling step of u0(t) and 3io(t)
d) calculating the complex admittance, i.e. amount |Y(t)|/ real part Yre(t)/ and imaginary part Yim(t)), in each sampling step k from the values filtered in step (c) and storing the results in a ring buffer
e) filling the ring buffer in each sampling step with the amount of the admittance
f) forming the following variables in each sampling step k from the ring buffer by means of the calculations for

$$\sum \underline{Y}(n) = \sum_{i=n-N+1}^{i=n} \underline{Y}_i$$

moving total of the admittance values:        moving total of the squares of the admit-

$$\sum \underline{Y}^2(n) = \sum_{i=n-N+1}^{i=n} \underline{Y}_i^2$$

tance values:        normalized variance of the admittance values:

$$\sigma^2(n) = \frac{N}{N-1}\left[\frac{N\sum \underline{Y}^2(n)}{\left(\sum \underline{Y}(n)\right)^2} - 1\right]$$

g) determining a fault or ground fault when exceeding the amount of the normalized variance with a threshold value in a sampling step, wherein the current sampling step therefore is the index of the fault occurrence $idx_{thr}$.

2. The method for detecting and/or locating ground faults according to claim 1, furthermore **characterized by** the following steps:

h) directional evaluation of the fault or ground fault by means of the following calculations and elimination of the prefaults of associated signals uo(t) und 3io(t) present in the ring buffer

1) storing n-prefault periods of uo(t) and 3io(t) from $idx_{thr}$ - n*N + N/2 to $idx_{thr}$ + N/2 in uo_buff_prefault and 3io_buff_prefault

$$u_{0,buff,prefault} = u_0\left(idx_{thr} - nN + \frac{N}{2} : idx_{thr} + \frac{N}{2}\right)$$

$$3i_{0,buff,prefault} = 3i_0\left(idx_{thr} - nN + \frac{N}{2} : idx_{thr} + \frac{N}{2}\right)$$

2) summation of the n prefault periods and normalisation

$$u_{0,buff,prefault,sum} = \frac{1}{n}\sum_{k=1}^{n} u_{0,buff,prefault}\left(1 + (k-1)N : kN\right)$$

$$3i_{0,buff,prefault,sum} = \frac{1}{n}\sum_{k=1}^{n} 3i_{0,buff,prefault}(1+(k-1)N:kN)$$

3) determining the direct component from the signals determined in step (2)

$$u_{0,buff,prefault,av} = \frac{1}{N}\int_{1}^{N} u_{0,buff,prefault,sum}$$

$$3i_{0,buff,prefault,av} = \frac{1}{N}\int_{1}^{N} 3i_{0,buff,prefault,sum}$$

4) deducting the direct component from the signals from step (2)

$$u_{0,buff,prefault,korr} = u_{0,buff,prefault,sum} - u_{0,buff,prefault,av}$$

$$3i_{0,buff,prefault,korr} = 3i_{0,buff,prefault,sum} - 3i_{0,buff,prefault,av}$$

5) deducting the prefault variables from the signals in step (1)

$$u_{0,buff,prefault,off} = u_{0,buff,prefault} - u_{0,buff,prefault,korr}$$

$$3i_{0,buff,prefault,off} = 3i_{0,buff,prefault} - 3i_{0,buff,prefault,korr}$$

i) recalculation of the fault-corrected admittance with the aid of an orthogonal filter. This results in $Y_{re,off}(t)$, $Y_{im,off}(t)$ and $|Y_{off}(t)|$

j) an evaluation interval with the limits eval_end_idx and eval_start_idx is initially determined for the directional evaluation as follows

    1) Finding the maximum from $|Y_{off}(t)|$ -> idx_max
    2) reverse search in $|Y_{off}(t)|$ starting from the index of the maximum up to the index idx_zero, at which no rise is any longer detected in $|Y_{off}(t)|$
    3) Eval_start_idx = idx_zero - N/10
    4) Eval_end_idx = idx_max + N/10

k) summation of the admittance values calculated in step (11):

$$Y_{eval,re,sum} = \frac{1}{\left(eval_{end,idx} - eval_{start,idx}\right)}\sum_{eval_{start,idx}}^{eval_{end,idx}} Y_{re,off}$$

$$Y_{eval,im,sum} = \frac{1}{\left(eval_{end,idx} - eval_{start,idx}\right)} \sum_{eval_{start,idx}}^{eval_{end,idx}} Y_{im,off}$$

1) directional determination based on a sign evaluation from the total admittance values determined in step (k)

| $Y_{eval,re,sum}$ | $Y_{eval,im,sum}$ | direction |
|---|---|---|
| + | + | backward |
| - | + | forward |
| - | - | forward |
| + | - | backward |

or

directional evaluation pulse locating, wherein the potential admittance change with safety factor, which is generated by the pulse equipment, is used as detection.

3. The method for detecting and/or locating transient ground faults according to claim 1,
**characterized in**
**that** the sampling rate is freely definable.

4. The method for detecting and/or locating transient ground faults according to claim 1,
**characterized in**
**that** the data processing of the buffered data and its evaluation takes place in a sliding manner in order to quickly detect changes.

5. The method for detecting and/or locating transient ground faults according to claim 1,
**characterized in**
**that** the sampling and determination of the respective residual voltage u0(t) and the total current 3io(t) takes place by means of prefiltering with a lowpass filter.

6. The method for detecting and/or locating transient ground faults according to claims 1 and 5,
**characterized in**
**that** predefined basic frequencies for the filter can be selected and/or harmonic frequencies are filtered and evaluated.

7. The method for detecting and/or locating transient ground faults according to claim 1,
**characterized in**
**that** the calculated admittance values are after the detection still written into the ring buffer for at least k_end sampling steps.

**Revendications**

1. Procédé de détection et/ou de localisation de défauts de terre transitoires dans des dérivations de câbles et/ou des câbles de réseaux d'alimentation électrique pour des résistances aux pannes jusque dans la plage de quelques kOhms, ce procédé comprenant les étapes suivantes :

a) balayage continu et enregistrement de la tension de transfert uO(t) du courant cumulé 3io(t) dans une sortie ;
b) enregistrement des valeurs de balayage dans un système de traitement de données doté d'un tampon de données ;

**caractérisé par** les étapes suivantes :

c) filtrage des valeurs balayées uo(t) et 3io(t) à l'aide d'un filtre numérique orthogonal en se référant à l'harmonique fondamentale pour déterminer les composants orthogonaux uoc(k) ou uos(k) ou uoc(k) ou ioc(k) ou ios(k) dans chaque étape de balayage d'uO(t) et 3io(t) ;

d) calcul de l'admittance complexe, c'est-à-dire du montant |Y(t)| , de la part réelle Yre(t) et de la part imaginaire Yim(t) ;

dans chaque étape de balayage k à partir des valeurs filtrées dans l'étape (c) et enregistrement des résultats dans une mémoire circulaire ;

e) remplissage de la mémoire circulaire dans chaque étape de balayage avec le montant de l'admittance ;

f) calcul des valeurs suivantes dans chaque étape de balayage k à partir de la mémoire circulaire au moyen des calculs pour la somme glissante des valeurs de l'admittance :

$$\sum \underline{Y}(n) = \sum_{i=n-N+1}^{i=n} \underline{Y}_i$$

$$\sum \underline{Y}^2(n) = \sum_{i=n-N+1}^{i=n} \underline{Y}_i^2$$

la somme glissante des carrés des valeurs d'admittance :                                                              la variance normalisée des valeurs d'admittance :

$$\sigma^2(n) = \frac{N}{N-1} \left[ \frac{N \sum \underline{Y}^2(n)}{\left( \sum \underline{Y}(n) \right)^2} - 1 \right] \quad ;$$

g) la constatation d'une erreur ou d'un défaut de terre en cas de dépassement du montant de la variance normalisée avec une valeur seuil dans une étape de balayage, l'étape de balayage actuel étant ainsi l'indice de l'apparition de l'erreur idxthr.

**2.** Procédé de détection et/ou de localisation de défauts de terre selon la revendication 1, **caractérisé en outre par** les étapes suivantes :

h) évaluation de l'orientation de l'erreur ou du défaut de terre au moyen des calculs suivants et élimination des erreurs préliminaires de signaux uo(t) et 3io(t) correspondants disponibles dans la mémoire circulaire.

1) Sauvegarde de n périodes d'erreur préliminaire d'uo(t) et 3io(t) de idxthr - n*N + N/2 à idxthr + N/2 dans uo_buff_prefault ou 3io_buff_prefault

$$u_{0,buff,prefault} = u_0 \left( idx_{thr} - nN + \frac{N}{2} : idx_{thr} + \frac{N}{2} \right)$$

$$3i_{0,buff,prefault} = 3i_0 \left( idx_{thr} - nN + \frac{N}{2} : idx_{thr} + \frac{N}{2} \right)$$

2) Totalisation des n périodes d'erreur préliminaire et normalisation

$$u_{0,buff,prefault,sum} = \frac{1}{n} \sum_{k=1}^{n} u_{0,buff,prefault} \left( 1 + (k-1)N : kN \right)$$

$$3i_{0,buff,prefault,sum} = \frac{1}{n} \sum_{k=1}^{n} 3i_{0,buff,prefault} (1 + (k-1)N : kN)$$

3) Détermination de la composante continue à partir des signaux déterminés dans l'étape (2)

$$u_{0,buff,prefault,av} = \frac{1}{N} \int_{1}^{N} u_{0,buff,prefault,sum}$$

$$3i_{0,buff,prefault,av} = \frac{1}{N} \int_{1}^{N} 3i_{0,buff,prefault,sum}$$

4) Soustraction de la composante continue des signaux de l'étape (2)

$$u_{0,buff,prefault,korr} = u_{0,buff,prefault,sum} - u_{0,buff,prefault,av}$$

$$3i_{0,buff,prefault,korr} = 3i_{0,buff,prefault,sum} - 3i_{0,buff,prefault,av}$$

5) Soustraction des valeurs d'erreur préliminaire des signaux dans l'étape (1)

$$u_{0,buff,prefault,off} = u_{0,buff,prefault} - u_{0,buff,prefault,korr}$$

$$3i_{0,buff,prefault,off} = 3i_{0,buff,prefault} - 3i_{0,buff,prefault,korr}$$

i) Recalcul de l'admittance corrigée de l'erreur à l'aide d'un filtre orthogonal.
On obtient alors $Y_{re,off}(t)$ , $Y_{re,off}(t)$ et $|Y_{off}(t)|$
j) Pour l'évaluation de la direction, un intervalle d'exploitation avec les limites eval_end_idx et eval_start_idx est d'abord défini comme suit.

1) Recherche du maximum à partir de $|Y_{off}(t)|$ -> idx_max
2) Recherche rétroactive dans $|Y_{off}(t)|$ à partir de l'index du maximum jusqu'à l'indice idx_zero dans lequel aucune pente n'est plus détectée dans $|Y_{off}(t)|$.
3) Eval_start_idx = idx_zero - N/10
4) Eval_end_idx = idx_max + N/

k) Totalisation des valeurs d'admittance 33 dans l'étape (11) :

$$Y_{eval,re,sum} = \frac{1}{\left(eval_{end,idx} - eval_{start,idx}\right)} \sum_{eval_{start,idx}}^{eval_{end,idx}} Y_{re,off}$$

$$Y_{eval,im,sum} = \frac{1}{\left(eval_{end,idx} - eval_{start,idx}\right)} \sum_{eval_{start,idx}}^{eval_{end,idx}} Y_{im,off}$$

1) Détermination de direction à partir d'une évaluation de signe à partir des valeurs d'admittance cumulées déterminées dans l'étape k)

| $Y_{eval,re,sum}$ | $Y_{eval,im,sum}$ | Direction |
|:---:|:---:|:---|
| + | + | Vers l'arrière |
| - | + | Vers l'avant |
| - | - | Vers l'avant |
| + | - | Vers l'arrière |

ou

évaluation de direction de localisation par impulsion, sachant qu'on utilise comme détection l'éventuelle modification d'admittance avec facteur de sécurité, qui est générée par le dispositif à impulsions.

3. Procédé de détection et/ou de localisation de défauts de terre transitoires selon la revendication 1, **caractérisé en ce que**
la vitesse de balayage est définissable librement.

4. Procédé de détection et/ou de localisation de défauts de terre transitoires selon la revendication 1, **caractérisé en ce que**
le traitement de données des données mises en tampon et leur exploitation ont lieu de manière glissante pour une détection rapide des modifications.

5. Procédé de détection et/ou de localisation de défauts de terre transitoires selon la revendication 1, **caractérisé en ce que**
le balayage et la détermination de la tension de transfert respective u0(t) et du courant cumulé 3io(t) ont lieu au moyen d'un filtrage préliminaire avec un filtre passe-bas.

6. Procédé de détection et/ou de localisation de défauts de terre transitoires selon la revendication 1, **caractérisé en ce que**
des fréquences de base prédéfinies peuvent être sélectionnées pour le filtre et/ou des fréquences harmoniques filtrées et exploitées.

7. Procédé de détection et/ou de localisation de défauts de terre transitoires selon la revendication 1, **caractérisé en ce que**
les valeurs d'admittance calculées sont inscrites dans la mémoire circulaire après détection au moins encore pour les étapes de détection k_end.

# FIG. 1

Messung
Verlagerungsspannung
an der Petersenspule

Messung
Verlagerungsspannung
an der offenen
Dreieckswicklung

# FIG. 2

Messung
Summenstrom per
Holmgreenschaltung

Messung
Summenstrom mit
Kabelumbauwandler

# FIG. 3

Messignale Leitungsabgänge

Fig. 4

## Fig. 5

Hüllkurven der orthogonalen Signale

# FIG. 6

Admittanz Abgang A

Admittanz Abgang B

## FIG. 7

Richtungsauswertung Admittanz

**IN DER BESCHREIBUNG AUFGEFÜHRTE DOKUMENTE**

**In der Beschreibung aufgeführte Patentdokumente**

- DE 10225058
- EP 0812427 A
- EP 1682909 A1
- AT 500195 A2
- US 2013043879 A1